# NEW EUROPEAN PATENT SPECIFICATION

(11) **EP 2 435 379 B2**
(45) Date of publication and mention of the opposition decision: **15.06.2022**
(45) Mention of the grant of the patent: 13.12.2017
(21) Application number: 10721846.3
(22) Date of filing: 21.05.2010
(51) Int. Cl.: C03C 23/00, C03C 17/36, C23C 14/02, C23C 14/18, C23C 14/58

(54) **PROCESS FOR MANUFACTURING A COATED GLASS ARTICLE**
VERFAHREN ZUR HERSTELLUNG EINES BESCHICHTETEN GLASARTIKELS
PROCÉDÉ DE FABRICATION D'UN ARTICLE EN VERRE MÉTALLISÉ

(30) Priority: 29.05.2009 GB 0909235
(43) Date of publication of application: 04.04.2012
(73) Proprietor: Pilkington Group Limited, Lathom, Nr. Ormskirk, Lancashire L40 5UF (GB)
(72) Inventor: CLARKE, Gregory, Charles, Bernard, Greater Manchester M5 4AH (GB); UNQUERA, Javier, S-302 46 Halmstad (SE); RIDEALGH, John, Andrew, Northwich Cheshire CW8 2TZ (GB); LAWTON, Dominic, Michael, Lancashire WN5 8NE (GB)
(74) Representative: Teasdale, Nicola Joanne
(86) International application number: PCT/GB2010/050831
(87) International publication number: WO 2010/136788

(56) References cited:
- WO-A2-2005/000758
- WO-A2-2008/008165
- WO-A2-2008/096089
- US-A1- 2003 033 983
- US-A1- 2009 011 194
- SAHU et al.: "Effect of substrate temperature and annealing treatment on the electrical and optical properties of silver-based multilayer coating electrodes", Thin Solid Films, vol. 515, no. 3, 2006, pages 932-935,
- ARBAB: "The base layer effect on the d.c. conductivity and structure of direct current magnetron sputtered thin films of silver", Thin Solid Films, vol. 381, 2001, pages 15-21,
- FANG et al.: "Effect of Vacuum Annealing on the Properties of Transparent Conductive AZO Thin Films Prepared by DC Magnetron Sputtering", Phys. Stat. Sol., vol. 193, no. 1, 2002, pages 139-152,
- Affidavit Mr. Jean-Thomas Fonne with experimental data

## Description

The invention relates to a process for manufacturing a coated glass article, particularly for manufacturing a coated flat glass substrate provided with a low-e and/or solar control coating.

More particularly the invention relates to a process for manufacturing a coated glass article as detailed in claim 1.

Such coated glass articles typically comprise at least one flat glass substrate made of soda-lime-silica glass or the like, particularly for use as a functional component in multiple glazings of the insulating or laminated glass type, for applications in vehicles, buildings or the like.

The glass substrate surface is provided with a coating to decrease its emissivity ("low-e coating") to achieve thermal insulation properties and/or to reduce its solar energy transmittance ("solar control coating") to shield interior rooms against the entry of excessive amounts of solar energy (heat).

The coating deposition process typically comprises a magnetron-enhanced reactive or non-reactive sputter deposition of the individual layers in a vacuum coating chamber with either of DC, medium frequency (AC) or RF sputtering from metal or compound targets, the invention not being restricted to a specific vacuum deposition process.

Low-e and solar control coatings typically comprise at least one metallic functional layer each of which is embedded between two anti-reflective layers, the metal of the functional layer(s) being selected from, e.g.,
- noble metals (Ag, Au, Cu, Pt, Pd) or alloys based on these noble metals to achieve a high IR reflectance at low visible light absorptance and high visible light transmittance, and/or
- non-noble metals such as Ni, Cr, Mo, Nb, W or alloys based on these metals to achieve a low solar energy transmission.

The invention primarily aims at improving the quality of functional layers consisting of silver or silver-based alloys (hereinafter referred to as "silver-based layers"), but is not restricted thereto.

The lower and upper anti-reflective coatings embedding the functional layer may serve a variety of purposes, their basic and primary function however being to reduce the visible light reflectance of the functional layer by interference effects. Each of the anti-reflective coatings may comprise only a single layer, or they may - most often - be composed of two or more partial layers. The anti-reflective coatings embedding the functional layer may - in addition to the transparent dielectric layers making up their major parts - comprise further auxiliary layers or components, e.g. primer layers, visible light and/or solar energy absorbing layers, diffusion barrier layers, protective layers, blocker or scavenger layers or the like, which need not necessarily consist purely of transparent dielectric materials but may comprise metallic, semiconductive and/or light absorbing layers or components, as well known in the art. In the context of this invention the term "anti-reflective coating" is provided with a broad meaning encompassing at least one transparent dielectric layer, but including also adjacent or embedded auxiliary layers or components (other than the functional layer) such as mentioned before, each anti-reflective coating as a whole being provided with an appropriate thickness to achieve the intended anti-reflection effect.

Generally it is aimed at achieving either - for a given IR reflectance or solar energy transmittance - the highest possible visible light transmittance, or - for a given visible light transmittance - the highest possible IR reflectance or lowest possible solar energy transmittance of the coated article. As the visible light transmittance of coatings of the above type is negatively correlated to the thickness of the functional layer - the thicker the functional layer, the lower its visible light transmittance - the achievement of such aims is supported by providing the functional layer with the highest possible specific conductivity or (equally) the lowest possible specific resistivity. An additional advantage of a low specific resistivity of metallic functional layers is the fact that for thinner functional layers a neutral reflection colour of the coated glass article is easier achievable.

To achieve high quality, low-resistance metallic functional layers, particularly when silver-based, it is known to select the lower anti-reflective coating such that it promotes the growth of the functional layers with high perfection and homogeneity so as to achieve a high specific conductivity. EP 0 747 330 A1 discloses coated glass articles with a coating provided with a lower anti-reflective coating comprising a layer of a suboxide of zinc and/or tantalum immediately below the silver-based functional layer to increase its specific conductivity. DE 197 26 966 C1 proposes to use a lower anti-reflective coating comprising a medium frequency sputtered titanium oxide layer adjacent to the glass substrate and a zinc oxide layer adjacent to the silver-based functional layer to achieve a significantly increased specific conductivity of the functional layer.

Other known approaches to improve the quality of coatings comprising at least one metallic (silver-based) functional layer consist of certain thermal post-treatments of the coated articles. Such post-treatments are based upon the finding that by the application of heat at appropriate temperatures imperfections in the metallic functional layer as deposited tend to heal and crystallites tend to grow, such the electron mobility in the functional layer is increased and its electrical resistance is thereby decreased.

EP 0 464 789 discloses a thermal post-treatment of a coated glass article with a coating having the layer sequence "glass / ZnO as lower anti-reflective coating / Ag as functional layer / ZnO as upper anti-reflective coating", wherein the thermal post-treatment comprises heat treating the coated article for about 1 h in an N₂ atmosphere at 400 °C.

DE 42 39 355 A1 proposes to apply a thermal post-treatment to coated glass articles comprising a coating with a layer sequence "glass / ITO / Ag / ITO", wherein the coated glass article is heat treated in an oven for about 1 h at up to 300 °C to decrease the sheet resistance of the silver functional layer.

DE 44 12 318 C1 discloses a thermal post-treatment of coated glass articles comprising a coating with a layer sequence "glass / SnO₂ + NiCr as lower anti-reflective coating / Ag as functional layer / NiCr + SnO₂ as upper anti-reflective coating", wherein the coated glass article is heat treated in an oven for at least 1 min., particularly for about 15 min., at 250 - 450 °C to decrease the sheet resistance and emissivity of the silver functional layer.

More recently WO 2008/008165 A2 and WO 2008/096089 A2 proposed certain thermal post-treatments of coated glass articles to improve their properties, particularly to increase the specific conductivity of coatings comprising metallic functional layers, particularly silver-based functional layers. While both publications prefer to apply such thermal post-treatments after the coated article left the vacuum coating chamber, they also consider the application of a thermal post-treatment of the coated glass article inside the vacuum coating chamber.

A thermal post-treatment of coated glass articles has a number of disadvantages. One disadvantage resides in the fact that a metallic functional layer typically reflects a high share of any IR radiation impinging on it so that a heat source with an increased power consumption is needed to achieve a specified temperature of the coated glass surface making the thermal post-treatment costly and time-consuming. When performing such a post-treatment outside the vacuum coating chamber the functional layer may oxidise by ambient air, thereby decreasing its quality. Post deposition heating may require additional processing steps, such as the manipulation and transport of coated glass articles, thereby affecting the cost effectiveness of the method. Heating coated glass articles for extended periods at elevated temperatures may lead to undesirable changes in the properties of the glass, for instance altering its optical properties and stress distribution.

It is also known to pre-heat glass substrates in an oven or the like before they are introduced into a vacuum coating chamber. Such procedure has the disadvantage that the temperature of the glass surface to be coated at the time when the individual layers of the coating are deposited, particularly when the functional layer is deposited, is difficult to control because between such substrate pre-heating and the actual deposition process a significant amount of time may pass and interim treatments may lead to an uncontrolled cooling of the pre-heated glass substrate. In addition hereto such pre-heating of glass substrates is time-consuming and ineffective.

The invention aims at providing an improved process for manufacturing coated articles of the type mentioned hereinbefore whereby an increased specific conductivity of the metallic functional layer is achieved more effectively. It particularly aims at applying a thermal treatment such that the energy transferred into the glass substrate is used more effectively. A further aim is to provide a manufacturing process by which the effect of a thermal treatment on the properties of the functional layer, particularly its specific conductivity, is better controllable.

According to the invention the thermal treatment is applied to the glass substrate after its introduction into the vacuum coating chamber and is - with respect to the deposition of a functional layer - performed as a thermal pre-treatment of the (partially coated) glass substrate surface to be coated such that it takes place immediately before actually depositing the functional layer.

The inventive thermal treatment is performed separately from any deposition step by the use of a thermal treatment device that does not deposit a layer on the glass substrate surface.

The thermal pre-treatment of the partially coated) glass substrate surface may preferably be achieved by applying IR or UV radiation. IR heating is easier to implement as high power lamp sources are readily available for use within an evacuated environment. High power UV lamp sources may be used for heating the glass substrate surface but they require a gas flow over the quartz envelope to prevent over heating. Other UV sources such as UV lasers may provide an alternative solution. A benefit of UV radiation over IR radiation is the very high absorption of UV radiation below 320 nm by glass which would give an energy efficiency advantage of a UV source over an IR source of equivalent power. UV radiation may be even more preferred when applied to UV-absorbing glass substrates or to partially coated substrates wherein the partial coating comprises at least one UV absorbing layer.

To provide an effective substrate surface heating the IR radiators are preferably selected and arranged such that the installed power is in a range of about 2 - 70 W/cm², preferably about 5 - 40 W/cm². High output IR sources enable higher line speeds of the substrate transported relative to the IR sources to be achieved whilst maintaining the same beneficial effect(s) to the functional layer. The efficiency of the IR heating source can be maximised by increasing the directionality of the IR radiation by the use of lenses or high IR reflectance mirrors to focus the radiation onto the glass substrate surface.

In a production situation the walls of the thermal treatment compartment would have to be water-cooled to prevent mechanical failures due to thermal expansion of the vacuum coating chamber walls and of components within the chamber.

Care would need to be taken in the design of a large scale heater such that the heating is uniform across the substrate width and designed so as to prevent significant temperature gradients across the glass substrate that would lead to glass breakages.

By applying the inventive thermal pre-treatment immediately before the functional layer is deposited the thermal energy is effectively transferred into the glass substrate surface without significant losses by subsequent radiative cooling and/or heat dissipation. The temperature increase caused by the inventive thermal pre-treatment primarily takes place in the glass substrate surface before the functional layer is deposited whereby a high effectiveness of the thermal treatment is achievable.

The inventive thermal pre-treatment is laid out such that the surface temperature of the (partially coated) glass substrate is increased to at least about 80 °C, preferably to at least about 100 °C, when measured immediately before the glass substrate enters the compartment of the vacuum coating chamber in which the functional layer is deposited. It was found that when increasing the glass substrate surface temperature to or above such temperatures a significant increase of the specific conductivity of the coating, as compared to an identical coating deposited without such thermal pre-treatment, is achievable.

Preferably the thermal treatment is laid out such that the glass substrate surface temperature, as measured immediately prior to the deposition of a functional layer, is increased to less than about 300 °C, preferably to at most about 250 °C, most preferably to no more than about 220 °C. Such upper limits, which are particularly applicable to silver-based functional layers, ensure that the functional layer is not damaged during its deposition by an overheated glass substrate surface. At the same time the amount of energy to be supplied to the substrate and to the vacuum coating chamber is hereby limited. It was found that by increasing the glass substrate surface temperature above these limits no major further improvement of the quality of functional layers, particularly when consisting of silver or a silver-based alloy, could be achieved.

According to the invention the thermal treatment takes place after the deposition of the lower anti-reflective coating and immediately before the deposition of the subsequent functional layer. By such provision the finally achieved quality of the functional layer, which was found to be strongly correlated to the surface temperature of the glass substrate to be coated during the deposition of the functional layer, is particularly well controllable.

The inventive process is particularly well suited to manufacture coated glass articles wherein the functional layer is deposited as a silver-based layer. It was found that by applying the inventive pre-treatment a favourable growth of the crystallites of a silver-based functional layer can be achieved such that relatively large crystallites having essentially the same crystalline direction - i.e. having their [111] crystal axis directed essentially perpendicular to the glass surface - grow upon the upper partial layer of the lower anti-reflective layer.

Independent hereof or in combination herewith it is preferred to apply the process to coated glass articles in which the lower anti-reflective coating comprises an upper partial layer adjacent to the functional layer which is deposited as a zinc oxide based layer. Zinc oxide based layers are known to provide already a preferred base for silver based functional layers, and the inventive thermal treatment further improves the advantageous effect of using a zinc oxide based silver growth promoting layer. Zinc oxide based layers consist primarily of zinc oxide. They may be doped with Al, Sn or the like as well known in the art.

The process is advantageously applied to coated glass articles in which the lower anti-reflective coating comprises a lower partial layer which is deposited adjacent to the glass substrate surface, the material of which lower partial layer is selected from (oxy)nitrides of silicon and/or aluminium, oxides of titanium, zirconium, niobium, tin, zinc and mixtures thereof, e.g. zinc tin oxide (particularly zinc stannate).

In addition to manufacturing coated glass articles comprising one basic layer sequence "glass / lower anti-reflective coating / functional layer / upper anti-reflective coating" ("single functional layer coatings") the coating may comprise further sequences of such type so as to improve its selectivity and other performance features as well known in the art ("multiple functional layers coating"), all of the functional layers being spaced by anti-reflective layers.

When depositing such multiple functional layer coatings the inventive thermal pre-treatment may take place at least immediately before depositing the first of the functional layers, but it may also take place immediately before depositing several of these or each of these.

The inventive process is particularly advantageous when applied to coated glass articles comprising a coating able to withstand high temperature heat treatments of the bending or thermal toughening type without major changes of their optical properties such as disclosed, e.g., in EP 0 718 250 A2, WO 02/062717 A1, WO 02/062717 A1, WO 2007/080428 A1. Such coated articles having stable optical properties may advantageously be used in mixed arrangements of glazings comprising toughened and non-toughened coated glass panes which makes them very attractive both for producers of coated articles and for their customers. Prior heat treatable coatings suffered however from the effect that - while by selecting appropriate coating designs the optical properties could be maintained essentially stable during a heat treatment of the bending or thermal toughening type - their sheet resistance and the correlated emissivity significantly decreased by these heat treatments such that the thermal properties (i.e. IR reflectance) of heat treated and non-heat treated were strongly different. While such heat treatment-induced quality improvement of functional layers, particularly of the silver-based type, is generally a well appreciated by-result of bending or thermal toughening processes it may effectively make the toughened and non-toughened products non-matchable so that they can't be offered as so-called "single stock products" because of their different thermal and electrical properties.

It was found that if the inventive pre-treatment is applied to heat treatable coatings being designed to have stable optical properties, not only their optical properties may be kept stable but also their emissivity and sheet resistance will be less affected by heat treatments of the bending and toughening type.

The invention is described hereinafter with reference to a drawing and examples of embodiment.

The figure shows:

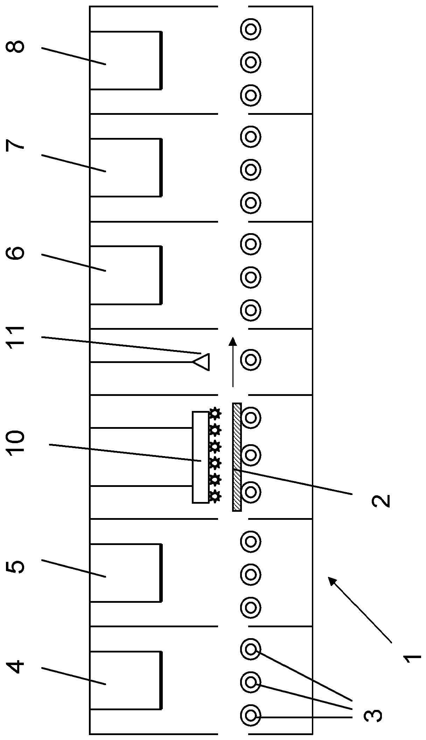

Fig. 1: a schematic setup of a vacuum coating chamber comprising a compartment for applying the inventive thermal treatment.

The exemplary vacuum coating chamber 1 of Fig. 1 is equipped with a magnetron cathode sputtering device and comprises a number of compartments located along the line of travel of a glass substrate 2 to be coated inside the vacuum coating chamber 1. The compartments may be gas-separated from each other by locks (not shown). Several compartments may be united to a common compartment without intervening wall or lock if no compartment separation is needed.

The glass substrate 2 is supported and transported through the vacuum coating chamber 1 by a number of rollers 3. Cathodes 4 - 8, that are provided at their lower surfaces with targets from which material may be sputter-coated onto the upper surface of the glass substrate 2, are arranged above the rollers 3.

In the - non-limiting - example shown the first compartment at the left side - at the entry of the vacuum coating chamber 1 - contains a cathode 4 for sputtering a first partial layer of a lower anti-reflective coating, the second compartment contains a cathode 5 for sputtering a second partial layer of a lower anti-reflective coating, the fifth compartment contains a cathode 6 for sputtering a functional layer, the sixth compartment contains a cathode 7 for sputtering a scavenger or blocker layer, and the seventh compartment near the exit of the vacuum coating chamber 1 contains a cathode 8 for sputtering an upper anti-reflective layer. Depending on the material of the targets and the coating to be achieved by sputtering the targets the compartments may be filled with a reactive or non-reactive sputter atmosphere. Each single cathode 4 - 8 may in practice comprise several separate cathodes arrange in one or several compartment(s).

In the third compartment a thermal treatment device 10 according to the invention is arranged. It comprises a number of IR radiation sources arranged such that the whole width of the glass substrate 2 can be heated to essentially the same surface temperature. The surface temperature increase achieved by the thermal treatment depends, e.g., upon the distance of the radiation sources of the thermal treatment device to the surface of the glass substrate 2, the power applied to the radiation sources, and the speed at which the glass substrate 2 is passing on the rollers 3 underneath the thermal treatment device 10.

In the fourth compartment that is located immediately ahead of the fifth compartment, in which the functional layer is deposited, in the embodiment shown a temperature measuring device 11 such as a pyrometer is arranged by which the temperature of the surface of the glass substrate 2 can be measured. The temperature measurement is not restricted to the use of pyrometers. The maximum surface temperature achieved during the thermal treatment may, e.g., be determined by using temperature stickers that are applied to the glass surface.

In a lab environment the thermal treatment device 10 comprised six 1 kW IR lamps which were each 40 cm long. The lamps were secured underneath a steel housing. The IR lamps were positioned at a distance of 10 cm from where the glass substrate 2 would pass during exposure. The temperature of the surface of the glass substrate 2 could be controlled by either adjusting the speed of the passing glass substrate 2 or by adapting the power setting of the IR lamps. The surface temperature of the glass substrate 2 was measured using an IR pyrometer as temperature measuring device 11 below which the heated glass substrate 2 passed immediately prior to the silver deposition compartment.

### Example 1

A low-e coating with the layer sequence:
TiO₂ 21 nm / ZnO:Al 5 nm / Ag 12 nm / ITO 3 nm / Zn-Sn oxide 40 nm

(ZnO:Al = Al-doped zinc oxide; ITO = indium tin oxide; Zn-Sn oxide = mixed zinc-tin oxide with about 50 wt.% each of zinc and tin) was sputter deposited on a 30 cm * 30 cm float glass substrate 2 having a thickness of 4 mm. A thermal treatment device 10 was provided so that the surface temperature of the glass substrate 2 could be raised to about 190 °C after the deposition of the silver growth promoting layer of ZnO:Al and immediately before the deposition of the silver layer. The thermal treatment device 10 comprised six 1 kW IR lamps each having a length of 40 cm and arranged with a spacing of about 5 cm such that they covered an area of about 1,200 cm², the installed power thus being about 5 W/cm². The IR lamps were positioned about 10 cm above the glass substrate 2. With this setup a glass substrate 2 passing underneath at about 0.5 m/min had its surface temperature raised to about 190 °C according to a temperature measuring device 11 consisting of an IR pyrometer positioned to monitor the top surface of the glass substrate 2 after the thermal treatment and immediately before the silver layer deposition. The sheet resistance of the layer stack was measured using a conventional Nagy sheet resistance measuring device.

It was observed that a reduction in the sheet resistance of the low-e coating of about 10 % was achieved by applying the inventive thermal pre-treatment as detailed in this Example 1. There was found to be no detrimental effect to the mechanical robustness of the stack. The light transmission T_{L} of the low-e coating that was thermally pre-treated by the method of this Example 1 increased by 1 % compared to the same coating that was not subjected to the inventive thermal pre-treatment. The effect of the thermal pre-treatment on the coated side reflection colour was to increase a* by about 0.5 and to decrease b* by about 0.5 (CIELAB colour system).

It was observed that the thermal pre-treatment of the glass substrate 2 in the vacuum coating chamber 1 resulted in an improvement of the crystallinity of the silver layer as evidenced by a more pronounced silver [111] peak of an XRD analysis of a treated sample compared to that of a non-treated sample.

### Example 2

In a further series of experiments always the same coating was deposited as in Example 1. The line speed of the glass substrate 2 was however varied. Passing the glass substrate 2 underneath the 6 * 1 kW IR heater at higher line speeds of 1 - 5 m/min resulted in a sheet resistance reduction of at least about 5 %. These line speeds can be translated into a glass surface temperature before depositing the silver layer of about 80 - 100 °C.

A degradation of the silver quality was observed for coatings deposited on a glass substrate 2 whose surface temperature was increased to about 300 °C, a surface temperature that was achieved by passing underneath the thermal treatment device 10 at less than about 0.4 m/min.

### Comparative Example

To support the finding of the inventors that by applying the inventive pre-treatment within the vacuum coating chamber 1, before the silver layer deposition, a significant benefit in treatment effectiveness can be achieved, as opposed to a post deposition heat treatment, a series of experiments was performed in which a coated article such as exemplified in Example 1 was heated treated after the deposition of the complete low-e coating rather the during its deposition. It was found that the coated glass substrate needed to be heated to a temperature of about 215 °C in a convection oven to achieve the same sheet resistance reduction of about 10 % as was achieved in Example 1 by pre-heating the glass substrate 2 to a surface temperature of 185 °C within the vacuum coating chamber 1, immediately prior to the deposition of the silver layer.

The invention is not limited to the coatings of the examples. The inventive thermal pre-treatment taking place before depositing the functional layer is applicable to a large variety of coatings, particularly all coatings with a silver-based functional layer comprising lower anti-reflective coatings comprising dielectric layers such as Si and/or Al nitride or oxynitride, oxides such as Zn oxide, Zn-Sn oxide, Ti oxide and the like.

## Claims

1. Process for manufacturing a coated glass article comprising the steps:
- introducing a glass substrate having a surface to be coated into a vacuum coating chamber,
- depositing on said glass substrate surface a multi-layer coating comprising in sequence from the glass substrate surface at least: a lower anti-reflective coating, a metallic IR-reflecting functional layer, and an upper anti-reflective coating,
- applying a thermal treatment to said glass substrate surface inside the vacuum coating chamber,
**characterized in that**
- said thermal treatment takes place immediately before depositing the functional layer, such that the glass substrate surface temperature is increased to at least 80 °C immediately before the functional layer is deposited.

2. Process according to claim 1, **characterized in that** the thermal treatment is achieved by applying IR or UV radiation.

3. Process according to claim 1 or 2, **characterized in that** the surface temperature is increased to at least 100 °C.

4. Process according to any of claims 1 to 3, **characterized in that** the surface temperature is increased to less than 300 °C.

5. Process according to claim 4, **characterized in that** the surface temperature is increased to at most 250 °C.

6. Process according to any of the preceding claims, **characterized in that** the functional layer is deposited as a silver-based layer.

7. Process according to any of the preceding claims, **characterized in that** the lower anti-reflective coating comprises an upper partial layer adjacent to the functional layer which is deposited as a zinc oxide based layer.

8. Process according to any of the preceding claims, **characterized in that** the lower anti-reflective coating comprises a lower partial layer which is deposited adjacent to the glass substrate surface, the material of which layer is selected from (oxy)nitrides of silicon and/or aluminium, oxides of titanium, zirconium, niobium, tin, zinc, and mixtures thereof.

## Patentansprüche

1. Verfahren zur Herstellung eines beschichteten Glasgegenstands, das die folgenden Schritte umfasst:
- Einbringen eines Glassubstrats, das eine zu beschichtende Oberfläche aufweist, in eine Vakuumbeschichtungskammer;
- Abscheiden einer mehrschichtigen Beschichtung auf dem Glassubstrat, die der Reihe nach ab der Glassubstratoberfläche mindestens umfasst: eine untere Antireflexionsbeschichtung, eine metallische IR-reflektierende Funktionsschicht und eine obere Antireflexionsschicht,
- Anwenden einer Wärmebehandlung auf die Glassubstratoberfläche innerhalb der Vakuumbeschichtungskammer,
**dadurch gekennzeichnet, dass**
- die Wärmebehandlung unmittelbar vor dem Abscheiden der Funktionsschicht so durchgeführt wird, dass die Glassubstratoberflächentemperatur unmittelbar vor dem Abscheiden der Funktionsschicht auf mindestens 80 °C erhöht wird.

2. Verfahren nach Anspruch 1, **dadurch gekennzeichnet, dass** die Wärmebehandlung durch Anwenden von IR- oder UV-Strahlung erfolgt.

3. Verfahren nach Anspruch 1 oder 2, **dadurch gekennzeichnet, dass** die Oberflächentemperatur auf mindestens 100 °C erhöht wird.

4. Verfahren nach einem der Ansprüche 1 bis 3, **dadurch gekennzeichnet, dass** die Oberflächentemperatur auf weniger als 300 °C erhöht wird.

5. Verfahren nach Anspruch 4, **dadurch gekennzeichnet, dass** die Oberflächentemperatur auf höchsten 250 °C erhöht wird.

6. Verfahren nach einem der vorhergehenden Ansprüche, **dadurch gekennzeichnet, dass** die Funktionsschicht als eine Schicht auf Silberbasis abgeschieden wird.

7. Verfahren nach einem der vorhergehenden Ansprüche, **dadurch gekennzeichnet, dass** die untere Antireflexionsbeschichtung eine obere Teilschicht angrenzend an die Funktionsschicht umfasst, die als eine Schicht auf Zinkoxidbasis abgeschieden wird.

8. Verfahren nach einem der vorhergehenden Ansprüche, **dadurch gekennzeichnet, dass** die untere Antireflexionsbeschichtung einen untere Teilschicht umfasst, die angrenzend an die Glassubstratoberfläche abgeschieden wird, wobei das Material der Schicht unter (Oxy)nitriden von Silicium und/oder Aluminium, Oxiden von Titan, Zirconium, Niob, Zinn, Zink und Gemischen davon ausgewählt wird.

## Revendications

1. Procédé de fabrication d'un article en verre revêtu, comprenant les étapes consistant à :
- introduire un substrat en verre présentant une surface à revêtir dans une chambre de dépôt sous vide,
- déposer sur ladite surface du substrat en verre un revêtement multicouche comprenant successivement, à partir de la surface du substrat en verre, au moins : un revêtement inférieur antireflet, une couche fonctionnelle métallique réfléchissant le rayonnement IR, et un revêtement supérieure antireflet,
- appliquer un traitement thermique sur ladite surface du substrat en verre à l'intérieur de la chambre de dépôt sous vide,
**caractérisé en ce que**
- ledit traitement thermique a lieu immédiatement avant le dépôt de la couche fonctionnelle, de sorte que la température de la surface du substrat en verre augmente jusqu'à au moins 80°C immédiatement avant le dépôt de la couche fonctionnelle.

2. Procédé selon la revendication 1, **caractérisé en ce que** le traitement thermique est réalisé par l'application d'un rayonnement IR ou UV.

3. Procédé selon la revendication 1 ou 2, **caractérisé en ce que** la température de la surface est augmentée jusqu'à au moins 100 °C.

4. Procédé selon l'une quelconque des revendications 1 à 3, **caractérisé en ce que** la température de la surface est augmentée jusqu'à moins de 300 °C.

5. Procédé selon la revendication 4, **caractérisé en ce que** la température de la surface est augmentée jusqu'à 250 °C au plus.

6. Procédé selon l'une quelconque des revendications précédentes, **caractérisé en ce que** la couche fonctionnelle est déposée sous forme de couche à base d'argent.

7. Procédé selon l'une quelconque des revendications précédentes, **caractérisé en ce que** le revêtement inférieur antireflet comprend une couche partielle supérieure adjacente à la couche fonctionnelle qui est déposée sous forme de couche à base d'oxyde de zinc.

8. Procédé selon l'une quelconque des revendications précédentes, **caractérisé en ce que** le revêtement inférieur antireflet comprend une couche partielle inférieure qui est déposée de manière adjacente à la surface du substrat en verre, le matériau de cette couche étant sélectionné parmi les (oxy)nitrures de silicium et/ou d'aluminium, les oxydes de titane, le zirconium, le niobium, l'étain, le zinc, et leurs mélanges.
